# EUROPEAN PATENT SPECIFICATION

(11) **EP 3 786 762 B1**
(45) Date of publication and mention of the grant of the patent: **02.07.2025**
(21) Application number: 20176990.8
(22) Date of filing: 28.05.2020
(51) Int. Cl.: G06F 1/18, H05K 1/14

(54) **SYSTEM, APPARATUS AND METHOD FOR PROVIDING A SYMMETRIC MULTI-PROCESSOR HIGH-SPEED LINK**
SYSTEM, VORRICHTUNG UND VERFAHREN ZUR BEREITSTELLUNG EINER SYMMETRISCHEN MEHRPROZESSOR-HOCHGESCHWINDIGKEITSVERBINDUNG
SYSTÈME, APPAREIL ET PROCÉDÉ POUR LA FOURNITURE D'UNE LIAISON DE MULTIPROCESSEUR SYMÉTRIQUE À GRANDE VITESSE

(30) Priority: 29.08.2019 US 201916555372
(43) Date of publication of application: 03.03.2021
(73) Proprietor: INTEL Corporation, Santa Clara, CA 95054 (US)
(72) Inventor: Aspnes, Brian, Portland, OR 97229 (US); Milobinski, Marc, Scappoose, OR 97056 (US); Schmisseur, Mark A., Phoenix, AZ 85048 (US)
(74) Representative: Samson & Partner Patentanwälte mbB

(56) References cited:
- WO-A1-2015/016843
- US-A1- 2005 230 852
- US-A1- 2007 079 041
- US-A1- 2009 108 416
- US-A1- 2019 044 293

## Description

### Technical Field

The invention relates to communication between multiple processors.

### Background

As computer technology advances, more servers are being designed with multiple processors. These multiple processors are adapted on a single main circuit board, called a motherboard or baseboard. To enable high-speed communication between these processors, routing layers with processor-to-processor interconnects are provided within this baseboard. However, with increasing core counts and increasing memory requirements, processor-to-processor communication consumes an increasingly high number of socket pins, which are the interconnections that connect a processor socket to the baseboard, and which are adapted within a so-called keep-out zone.

As technology advances with ever-increasing core counts and memory requirements, greater numbers of these space-constrained socket pins are required for enabling multi-socket communication. As such, baseboards are designed with increasingly expensive materials and greater numbers of layers, which further complicate design including routing issues, and increase costs and power consumption.

US 2005/0230852 A1 describes a board attached to substrate of a semiconductor chip package. US 2009/0108416 A1 describes a plurality of electric signal conductors extend between the first and second integrated circuit packages suspended above a printed circuit board. WO 2015/016843 A1 describes a connector comprising a plurality of signal paths for routing signals from the first and second CPU packages.

### Summary of the invention

The invention is defined in independent claim 1.

Preferred embodiments are defined in the dependent claims

### Brief Description of the Drawings

FIG. 1 is a block diagram of an auxiliary circuit board in accordance with an embodiment of the present invention.
FIG. 2 is a block diagram of a processor package in accordance with an embodiment of the present invention.
FIG. 3 is a cross-sectional view of mating between a processor package and an edge connector of an auxiliary circuit board in accordance with an embodiment of the present invention.
FIG. 4 is a block diagram illustrating a server computer providing for interconnection of multiple processor sockets with an auxiliary circuit board in accordance with an embodiment.
FIG. 5 is a block diagram of a server computing system having an auxiliary circuit board in accordance with another embodiment of the present invention.
FIG. 6 is a block diagram of a multi-server computer system in accordance with an embodiment of the present invention.
FIG. 7 illustrates an example computing node arrangement, according to various embodiments
FIG. 8 illustrates another example computer device that may employ the apparatuses and/or methods described herein.

### Detailed Description

In various embodiments, a multi-processor computing system such as a server computer may include an auxiliary circuit board to directly couple at least two processors of the multi-processor computing system. With embodiments, these processors communicate without use of interconnects of one or more layers of a main circuit board such as a baseboard, motherboard or so forth to which the processors are adapted. In this way, processor-to-processor communication may occur exclusively via this auxiliary circuit board. Thus fewer socket pins, solder balls or other interconnection members within a pin field of the processors are consumed. Instead, the multiple processors may have edge connection members to which the auxiliary circuit board may be adapted.

As a result, fewer signals pass through processor sockets, reducing the number of required socket pins, solder balls or other connection members located within a keep-out zone of a processor package. In addition, by moving high-speed processor-to-processor signaling onto a separate smaller auxiliary circuit board, the main baseboard is not burdened with the cost of ultra-low loss circuit board materials. And with an auxiliary circuit board as described herein, airflow in a manufactured system is not blocked by other interconnection members that would be required in other systems, such as thick cabling to couple between accelerator cards and the baseboard. Still further, by separating out processor-to-processor signaling onto this auxiliary circuit board, crosstalk between such signaling and other board components such as voltage regulators is reduced or completely avoided.

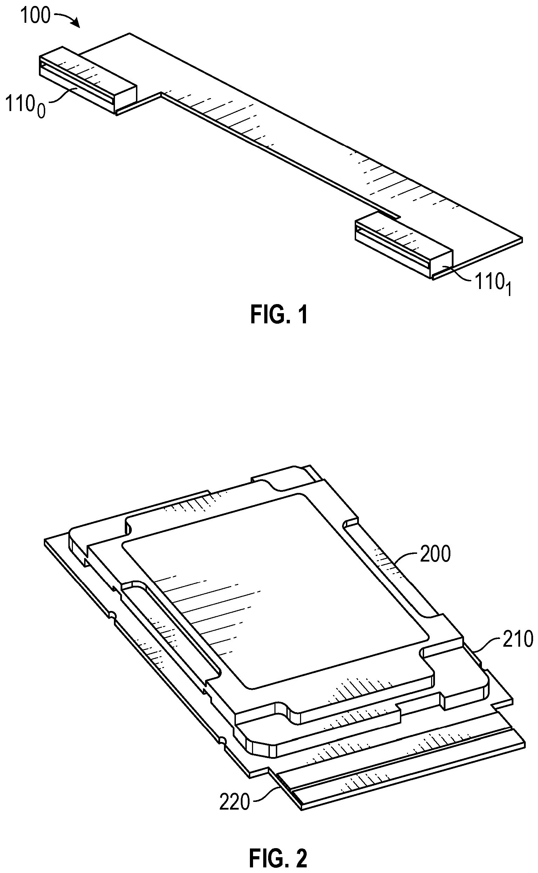

Referring now to FIG. **1****,** shown is a block diagram of an auxiliary circuit board in accordance with an embodiment of the present invention. As shown in FIG. **1****,** circuit board 100 may provide a high-speed link between multiple processors within a multi-processor computing system. As illustrated in FIG. **1****,** circuit board 100 includes multiple connectors 110_{0,1}, each adapted at a corresponding peripheral portion of circuit board 100. As high-speed signaling is to occur between the processors via circuit board 100, the circuit board may be formed of an ultra-low loss material, to improve signaling speeds. In the embodiment of FIG. 1, note that there are no locations on circuit board 100 to which an integrated circuit may be adapted (such as by socket pins, solder balls or so forth). Instead circuit board 100 can only couple to processors via connectors **110.**

Circuit board 100, which in different embodiments may be a multi-layer circuit board having between approximately 2 and 10 layers, can be formed of a printed circuit board (PCB) material having ultra-low loss properties similar to EM-891, IT-988G, TU-883, TU-933+, MEG6, MEG7, etc. In embodiments, ultra-low loss materials may have a dielectric constant (Er) of approximately 3.4 and a dissipation factor (Df) of approximately 0.0018 (at 1 gigahertz (GHz)). In contrast, a baseboard of a server system may be formed of a lower cost, lower speed material such as a glass-reinforced epoxy laminate material (e.g., FR-4) or the like. As a result, a manufacturer such as OEM may realize significantly reduced manufacturing costs by leveraging an auxiliary board to route high-speed inter-processor signaling. Of course, in other cases similar performance may be realizing using low loss materials (having higher dielectric constant and dissipation factor) and shorter traces. More generally in embodiments, an auxiliary circuit board may have more aggressive/higher cost loss mitigation techniques as compared to the larger/cheaper baseboard. Thus the main and much larger baseboard can be formed of a lower cost material.

In addition, by providing an auxiliary circuit board, the main baseboard can be formed with fewer layers, e.g., between approximately 10 and 12 layers, and which can be formed of a PCB material having higher loss properties similar to FR-408, 370HR, etc. In an embodiments, such materials may have a dielectric constant of approximately 3.8 and a dissipation factor of approximately 0.0125 (at 1 gigahertz (GHz)). In contrast, without an embodiment the baseboard may require at least 4-6 additional layers, and further require manufacture with a higher cost material. While the above discussion assumes particular classes of materials for the different circuit boards.

To enable processors to couple to auxiliary board 100 without consuming socket pins, solder balls or so forth, processors in accordance with an embodiment may have packages that include edge connectors, in addition to such socket pins, solder balls or other interconnection members. In turn, these edge connectors or contact members provide coupling to corresponding connectors **110** of circuit board 100. Referring now to FIG. 2, shown is a block diagram of a processor package in accordance with an embodiment of the present invention. As shown in FIG. 2, processor package 200 may be implemented as an integrated circuit package including one or more semiconductor die coupled to a package substrate. As illustrated in FIG. 2, at a first edge portion 210 of package 200, an edge connector 220 is formed directly on a substrate of package 200.

In the embodiment shown in FIG. 2, note that edge connector 220 may be formed as a stepped connector including two levels of finger contacts. In an embodiment these fingers may be implemented as gold-plated fingers to provide interconnection to internal routing lines of the one or more semiconductor die. Although shown with two levels of contacts in the embodiment of FIG. 2, understand that in other embodiments a single level or more than two levels may be provided. Further, while FIG. 2 shows an embodiment having a single edge connector per processor package, understand that the scope of the present invention is not limited in this regard and in other cases, separate edge connectors may be provided on opposite sides of a package (and it is even possible to provide edge connectors on all sides of a package, in still further embodiments). The number of individual finger contacts of these edge connectors may vary in different embodiments. In typical use cases, between approximately 128-256 contacts may be provided.

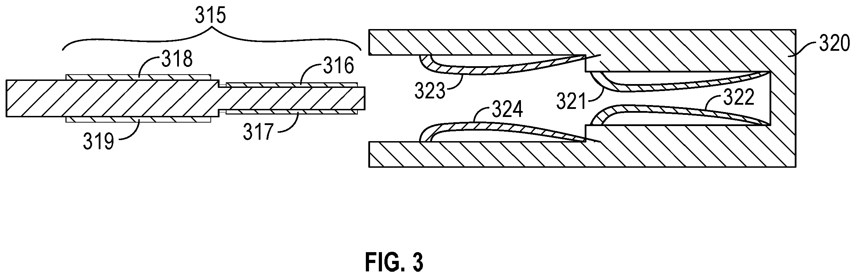

Referring now to FIG. 3, shown is a cross-sectional view of mating between a processor package and an edge connector of an auxiliary circuit board in accordance with an embodiment of the present invention. As shown in FIG. 3, a processor has an edge contact member 315, which more specifically is shown in the cross-section of FIG. 3 as fingers 316, 317 of a first level and fingers 318, 319 of a second level. In turn, when adapted within an edge connector 320 of an auxiliary circuit board, contact is made between these corresponding fingers and corresponding connector pins of a stepped pin assembly including pins 321, 322 of a first level of connector pins and pins 323, 324 of a second level of connector pins. Although shown at this high level in the embodiment of FIG. 3, many variations and alternatives are possible, and other connection mechanisms for interconnecting a processor package directly to an auxiliary circuit board without consuming socket pins, solder balls or so forth may be used.

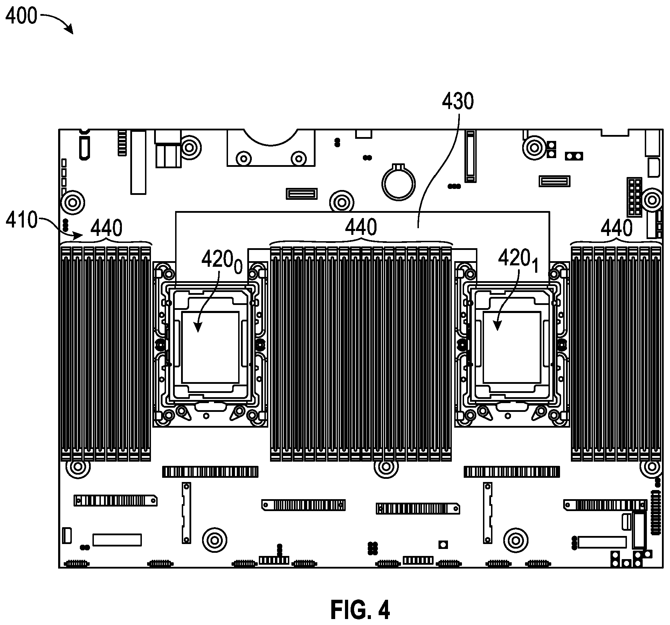

Referring now to FIG. 4, shown is a block diagram illustrating a server computer providing for interconnection of multiple processor sockets with an auxiliary circuit board in accordance with an embodiment. As shown in FIG. 4, a server computer 400 includes a baseboard 410 to which multiple processor packages 420_{0,1} are adapted. In different implementations, processor packages 420 may be implemented within sockets having socket pins that are connected to baseboard 410. In another implementation, processor packages 420 may be adapted as a ball grid array package having solder balls that in turn connect to solder bumps on baseboard 410.

In any case note that processor-to-processor communication is solely via an auxiliary circuit board 430 that directly couples processor packages 420 together. In different embodiments, such processor-to-processor communication may be according to a variety of different communication protocols. For example, some embodiments may be implemented by way of one or more of an Intel^{®} Ultra Path Interconnect (UPI) communication protocol, an Intel^{®} Quick Path Interconnect (QPI) communication protocol, and/or a given Compute Express Link (CXL) specification-based communication protocol such as in accordance with the CXL Specification version 1.1. In yet other embodiments, processor-to-processor communication may be accordance with an IBM XBus protocol, or an Nvidia NVLink protocol, an AMD Infinity Fabric protocol, among many other such communication protocols.

As further illustrated in FIG. 4, a plurality of memory modules 440, which may be implemented as dual in-line memory modules (DIMMs), couple between and outwardly from processors 420. With the implementation shown in FIG. 4, processor-to-processor communication is not passed through socket pins or solder balls, reducing pin/ball count. In addition, such signaling is not exposed to crosstalk, e.g., from one or more voltage regulators adapted to baseboard 410. Furthermore, a thinner baseboard may be realized, as fewer layers may be required, given this baseboard-external routing of processor-to-processor signaling.

In addition with adaptation of auxiliary circuit board 430, system airflow is not blocked (as auxiliary circuit board 430 may be adapted horizontally (and parallel to baseboard 410)). Thus airflow passing through system (such as in a vertical direction in the illustration of FIG. 4) may flow directly across heatsinks adapted to processors 420 and not be blocked by auxiliary circuit board 430. In addition, a variety of system cards may be adapted above and around auxiliary circuit board 430 in an unrestricted manner.

Although shown at this high level in the embodiment of FIG. 4, many variations and alternatives are possible. For example, while FIG. 4 shows an implementation in which processors 420 are adapted adjacent to each other in a width direction (in the illustration of FIG. 4), it is also possible that processors 420 may be adapted adjacent each other in a length direction (in the illustration of FIG. 4), such that an auxiliary circuit board may be formed as a substantially rectangular board to enable direct interconnection between multiple processors located one in front of the other. Such arrangement stands in contrast to the arrangement of circuit board 420 as a partial frame configuration (having two vertical portions and a single horizontal portion (as illustrated in FIG. 4)). And of course other configurations and positioning of processors and corresponding auxiliary circuit boards are possible.

Still further, while the above embodiments describe an auxiliary circuit board to which no integrated circuits are adapted by way of pins, solder balls or another surface mount technology or board-based connectors (other than the edge connectors described above), in other cases, an auxiliary circuit board may also be used to attach devices such as accelerators and peripheral devices directly or via connectors to which cables can be attached. In such cases, the auxiliary circuit board may include interconnects sufficient to enable at least one Peripheral Component Interconnect Express (PCIe) interface, which may consume 64 interconnects/contacts. Where it is desired to provide for multiple PCIe interfaces, some multiple of 64 contacts may be provided by way of one or more edge connectors of a processor. And of course, other high speed links such as Intel^{®} UPI and/or QPI links, CXL links, NVLinks and so forth.

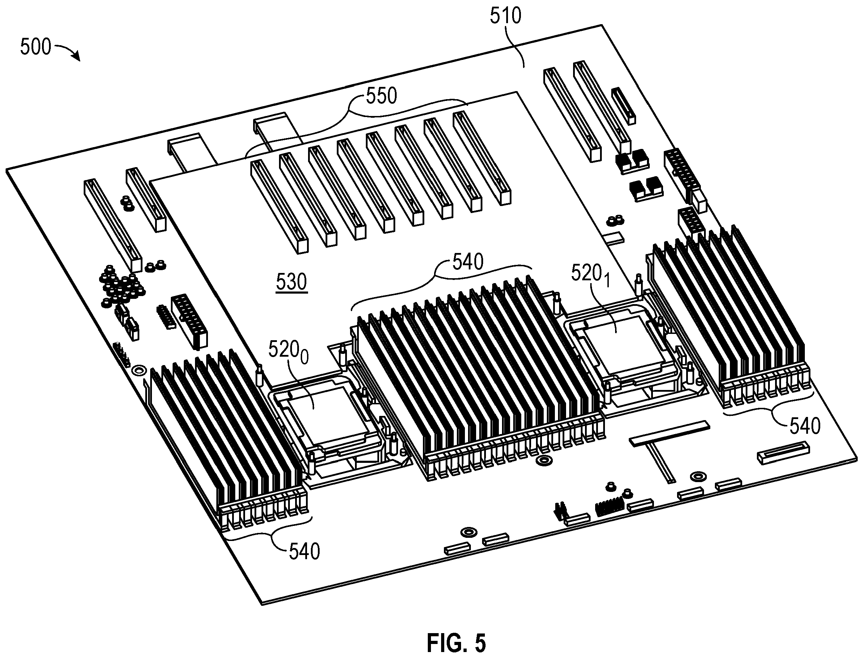

Referring now to FIG. 5, shown is a block diagram of a server computing system having an auxiliary circuit board in accordance with another embodiment of the present invention. As shown in FIG. 5, server system 500 includes a baseboard 510, processors 520_{0,1}, an auxiliary circuit board 530, and memory 540. In the embodiment of FIG. 5, auxiliary circuit board 530 may be larger than the above-described auxiliary circuit boards and may provide for multiple interconnection members to which I/O devices can be coupled to, e.g., by way of one or more connectors 550. These I/O devices may take the form of add-in cards, such as accelerators, additional memory so forth. In addition, while card connectors are shown in the implementation of FIG. 5, it is also possible to provide cable-based connectors, to enable coupling of other devices such as a graphics accelerator card or so forth by way of cable connection. In an example embodiment, assume that auxiliary circuit board 530 includes 4 sets of links per CPU (e.g., where each link includes 64 signal lines), one or more of these links may be used by one or more devices that couple to auxiliary circuit board 530 by way of connectors 550.

With an embodiment as in FIG. 5, further reductions in numbers of signals that extend through processor packages 520 (and any socket) through baseboard 510 may be realized, increasing advantages in such embodiments. In addition, with auxiliary circuit board 530 providing additional connectors as in FIG. 5, greater OEM flexibility may be realized. That is, an OEM may design a single baseboard and provide multiple stock keeping units (SKUs) using this single baseboard. As an example for one SKU a basic auxiliary circuit board (as described above with regard to FIG. 1) may be used, while for another SKU an auxiliary circuit board as in FIG. 5 may be used, to provide a server computer that enables inclusion of additional devices.

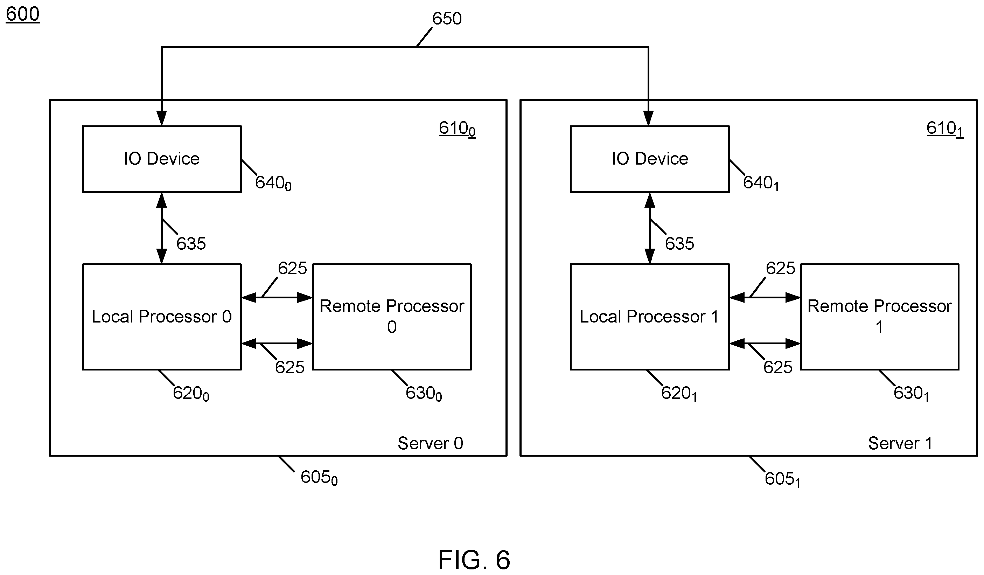

Referring now to FIG. 6, shown is a block diagram of a multi-server computer system in accordance with an embodiment of the present invention. As shown in FIG. 6, system 600 may be all or a portion of a system having at least two servers 605_{0,1}, each adapted on a different baseboard 610_{0,1}. As one example, system 600 maybe a rack-based server including many baseboards adapted in a frame such as a 42U height rack.

In any event, each server 605, also referred to herein as a node, includes symmetric multi-processors, namely processors 620_{0,1} and 630_{0,1}, namely multicore processors. In some embodiments, all of these processors may be identical, or different processor types may be implemented in each server. To enable processor-to-processor communication internally to each server 610, a set of interconnects 625 is provided to couple processors 620 and 630. And in embodiments herein, understand that interconnects 625 may be implemented within an auxiliary circuit board as described herein, separate from baseboard 610.

With further reference to the high level view shown in FIG. 6, each server 605 further includes an I/O device 640_{0,1}. Note that each I/O device 640 is directly coupled via another interconnect 635 to a corresponding local processor 620. Thus the identification of processors as being local or remote is with respect to I/O device 640, such that the processor to which it is directly coupled is the local processor, and the other symmetric processor is considered the remote processor. Although not shown for ease of illustration, understand that additional I/O devices or other components may be directly coupled to remote processor 630.

In one embodiment, interconnects 625 may be implemented in an auxiliary circuit board (not shown in the logical view of FIG. 6), and may carry processor-to-processor communication according to an Intel^{®} UPI communication protocol, although other protocols are possible. In an embodiment, each interconnect 625 may be configured as an x16, x20 or x24 with ports that couple processors 620, 630 together.

In an embodiment, interconnect 635 may carry communications according to a PCIe or other communication protocol. Understand that in some embodiments, an auxiliary circuit board (which includes interconnects 625) may further include interconnects 635 in a manner separated from baseboard 610. To this end, such auxiliary circuit board may take the form, e.g., as shown in FIG. 5, such that I/O device 640 may be adapted within a connector of the auxiliary circuit board (or coupled by way of a cable connector), or otherwise directly coupled to the auxiliary circuit board.

Still referring to FIG. 6, communication between servers 605 may be via a high speed fabric interconnect 650. In different embodiments, interconnect 650 may be implemented using an InfiniBand or Ethernet-based protocol, and may be realized using Ethernet or optical cables that couple baseboards 610 together.

With the arrangement in FIG. 6, remote processor 630₀ may communicate with remote processor 630₁ along a path including interconnects 625, 635 and via I/O devices 640_{0,1} and via interconnect 650, and finally through interconnects 625, 635 of baseboard 610₁ to remote processor 630₁. Understand while shown at this high level in the embodiment of FIG. 6, many variations and alternatives are possible.

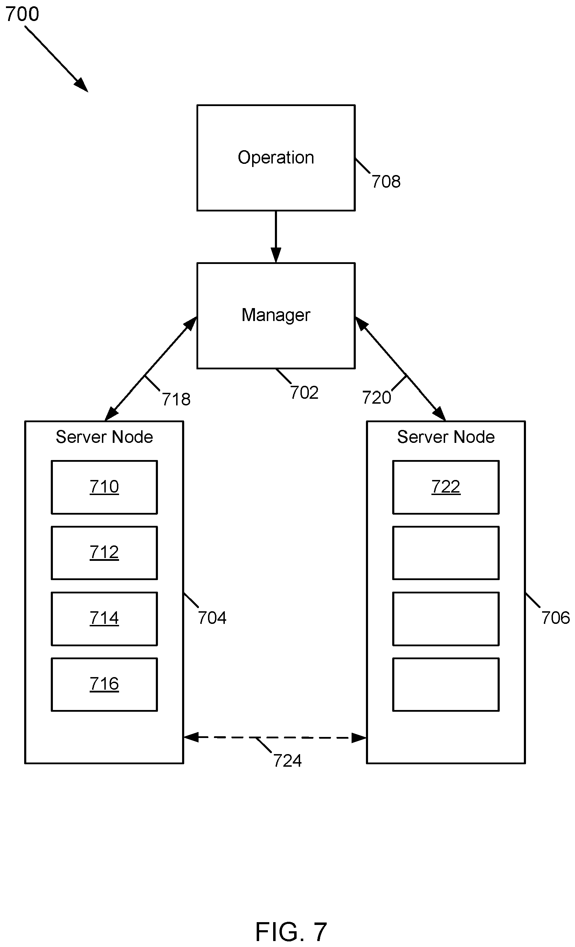

FIG. 7 illustrates an example computing node arrangement 700, according to various embodiments. The computing node 700 may include a manager 702 and one or more server nodes, such as server node 704 and server node 706. The one or more server nodes may be communicatively coupled to the manager 702, thereby allowing communication between the between the server nodes and the manager 702 (as illustrated by communication link 718 and communication link 720). The manager 702 and each of the server nodes may be referred to as a computing node. The following description refers to the server node 704 and the server node 706, however, it is to be understood that any of the server nodes within the one or more server nodes may include one or more of the feature of the server node 704, the server node 706, or some combination thereof.

The manager 702 may receive an operation 708 to be performed. The manager 702 may include one or more communication chips. The manager 702 may wirelessly receive or wiredly receive the operation 708 from a requesting device via the communication chips. The manager 702 may separate the operation 708 into one or more discrete operations and/or data groupings for storage.

The server node 704 may be a server rack. The server node 704 may include one or more drawers (which may also be referred to as sleds), such as drawer 710, drawer 712, drawer 714, and drawer 716. The server node 704 may be arranged in a pooled-by-node arrangement. In the pooled-by-node arrangement, each of the drawers of the server node 704 may include one or more components to provide a certain resource type. The resource types may include a network resource type, a storage resource type, and a compute resource type. For example, the drawer 710, the drawer 712, the drawer 714, and the drawer 716 may each include components to provide a compute resource type.

In other embodiments, the server node 704 may be arranged in a pooled-by-drawer arrangement. In the pooled-by-drawer arrangement, each of the drawers may include one or more components to provide a certain resource type, but each of the drawers may include components to provide a different resource type than provided by the components within another one of the drawers of the server node 704. For example, the drawer 710 may include components to provide a network resource type, the drawer 712 may include components to provide a storage resource type, and the drawer 714 may include components to provide a compute resource type.

Further, in other embodiments, the server node 704 may be arranged in a heterogeneous arrangement. In the heterogeneous arrangement, each of the drawers may include components to provide multiple resource types. Each of the drawers may include components to provide all the resource types or some portion of the resource types. For example, the drawer 710 may include components to provide a network resource type, components to provide a storage resource type, and components to provide a compute resource type.

In some embodiments, the server node 704 may be arranged in a combination of the pooled-by-drawer arrangement and the heterogeneous arrangement. In these embodiments, a first portion of the drawers of the server node 704 may be arranged in the pooled-by-drawer arrangement and a second portion of the drawers may be arranged in the heterogeneous arrangement.

The server node 706 may include one or more of the features of the server node 704. The server node 706 may have a same arrangement as the server node 704 or may have a different arrangement than the server node 704. For example, the server node 704 may be arranged in a pooled-by-node arrangement and the server node 706 may be arranged in a pooled-by-drawer arrangement. As stated above, the resource types may include the network resource type, the storage resource type, and the compute resource type. The network resource type may include one or more components that may provide networking capability. The storage resource type may include one or more components that may provide storage capability. The compute resource type may include one or more components that may provide computing capability.

In some embodiments, the resource types may include other resource types not described, but would be understood to be other resource types that may be provided by a server rack known to one having skill in the art. Further, in some embodiments, the resource types described may be divided into narrower resource types, where each of the narrower resource types may include some portion of the components described above in relation to the network resource type, the storage resource type, and the compute resource type.

After separating the operation 708 into one or more discrete operations and/or data groupings for storage, the manager 702 may direct each of the discrete operations and/or data groupings for storage to a corresponding drawer of the server node 704 and/or the server node 706 that provides the resource type to perform the discrete operation or store the data grouping. For example, the manager 702 may separate the operation 708 into a calculation operation and a group of data to be stored. The manager 702 may direct, via the communication link 718, the calculation operation to the drawer 710 of the server node 704, which may provide the compute resource type, and may direct, via the communication link 720, the group of data to be stored to drawer 722 of the server node 706, which may provide the storage resource type.

After directing the discrete operations and/or the data groupings for storage to the corresponding drawers, the manager 702 may retrieve the results of the discrete operations and/or the data groupings at a time when the results of the operation 708 are to be returned to the requesting device via the communication chips. The manager 702 may combine the results of the discrete operations and/or the data groupings to generate the results of the operation 708 and may return the results of the operation 708 to the requesting device via the communication chips.

In instances where the discrete operations are completed prior to the time when the results of the operation 708 are to be returned to the requesting device, the manager 702 may receive the results of the discrete operations and may direct the results of the discrete operations to a drawer providing the storage resource type for storage. The manager 702 may then retrieve the results of the discrete operations from the drawer providing the storage resource type at the time when the results of the operation 708 are to be returned to the requesting device.

In some embodiments, the manager 702 may be omitted from the computing node arrangement 700. In these embodiments, one or more drawers of one of the server nodes may perform the operations of the manager 702. For example, the drawer 710 of the server node 704 may perform the operations of the manager 702 and may direct the discrete operations and/or data groupings to other drawers within the server node 704 and/or within the server node 706. Further, in these embodiments, the server node with the drawer that performs the operations of the manager 702 may be communicatively coupled to the other server nodes within the computing node arrangement 700 (as illustrated by communication link 724).

One or more of the computing nodes within the computing node arrangement 700, and/or the drawers within the computing nodes, may include, and/or may be, a computer device having multiple symmetric (or asymmetric) processors that are coupled together via one or more auxiliary circuit boards in accordance with an embodiment.

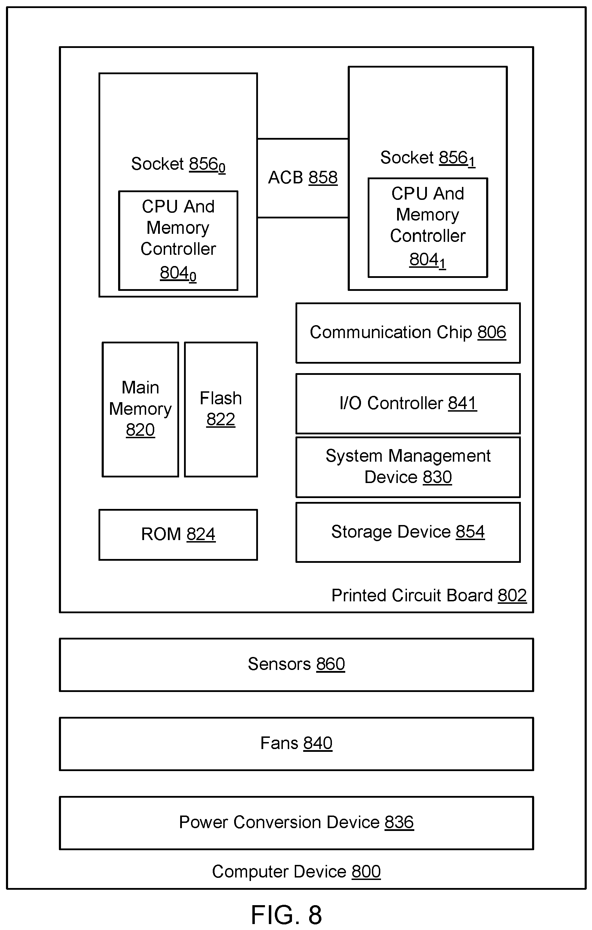

FIG. 8 illustrates an example computer device 800 that may employ the apparatuses and/or methods described herein, in accordance with various embodiments. As shown, computer device 800 may include a number of components, such as a plurality of processor and memory controller device(s) (hereafter CPUs) 804_{0,1} and at least one communication chip 806. In various embodiments, the CPUs 804 each may include one or more processor cores.

Further, in various embodiments, a system management device 830 (such as baseboard management controller (BMC)) may be coupled to the CPUs 804. The system management device 830 may monitor the state of the computer device 800 via one or more sensors 860. The one or more sensors 860 may sense the physical state of the computer device 800, such as a temperature of the computer device 800. In some embodiments, the system management device 830 may communicate with the CPUs 804 through an independent connection. Further, in some embodiments, the system management device 830 and/or the sensors 860 may be omitted.

In various embodiments, computer device 800 may include printed circuit board (PCB) 802, which may be a baseboard. For these embodiments, the CPUs 804 (e.g., adapted in a socket 856_{0,1}) and communication chip 806 may be disposed thereon. However, processor-to-processor signaling between CPUs 804 may occur via interconnects included in layers of auxiliary circuit board 858. In alternate embodiments, the various components may be coupled without the employment of PCB 802. Depending on its applications, computer device 800 may include other components that may or may not be physically and electrically coupled to the PCB 802. These other components include, but are not limited to, main memory (e.g., volatile memory, non-volatile memory, and/or dynamic random access memory (DRAM) 820), read-only memory (ROM) 824, flash memory 822, storage device 854 (e.g., a hard-disk drive (HDD)), an I/O controller 841, a digital signal processor (not shown), a crypto processor (not shown), a system management device 830, a display (not shown), a power conversion device 836, an audio codec (not shown), a video codec (not shown), and a mass storage device (such as hard disk drive, a solid state drive, compact disk (CD), digital versatile disk (DVD)) (not shown), and so forth.

In various embodiments, the computer device 800 may include one or more fans 840. The one or more fans 840 may be directed at and/or mounted to one or more of the components within the computer device 800. In some embodiments, the one or more fans 840 may be coupled to the CPUs 804 and/or the system management device 830, which may control operation of the one or more fans 840.

In some embodiments, the CPUs 804, flash memory 822, and/or storage device 854 may include, stored in a non-transitory storage medium, associated firmware (not shown) storing programming instructions configured to enable computer device 800, in response to execution of the programming instructions by one or more processor and memory controller device(s) 804, to practice all or selected aspects of the methods described herein. In various embodiments, these aspects may additionally or alternatively be implemented using hardware separate from the one or more processor and memory controller device(s) 804, flash memory 822, or storage device 854.

The communication chips 806 may enable wired and/or wireless communications for the transfer of data to and from the computer device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to IEEE 802.20, Long Term Evolution (LTE), LTE Advanced (LTE-A), General Packet Radio Service (GPRS), Evolution Data Optimized (Ev-DO), Evolved High Speed Packet Access (HSPA+), Evolved High Speed Downlink Packet Access (HSDPA+), Evolved High Speed Uplink Packet Access (HSUPA+), Global System for Mobile Communications (GSM), Enhanced Data rates for GSM Evolution (EDGE), Code Division Multiple Access (CDMA), Time Division Multiple Access (TDMA), Digital Enhanced Cordless Telecommunications (DECT), Worldwide Interoperability for Microwave Access (WiMAX), Bluetooth, derivatives thereof, as well as any other wireless protocols that are designated as 3G, 4G, 5G, and beyond. The computer device 800 may include a plurality of communication chips 806. For instance, a first communication chip 806 may be dedicated to shorter range wireless communications such as Wi-Fi and Bluetooth, and a second communication chip 806 may be dedicated to longer range wireless communications such as GPS, EDGE, GPRS, CDMA, WiMAX, LTE, Ev-DO, and others.

In various implementations, the computer device 800 may be a server. In other implementations, the computer device 800 may be, or components of the computer device 800 may be implemented in, a laptop, a netbook, a notebook, an ultrabook, a smartphone, a computer tablet, a personal digital assistant (PDA), an ultra-mobile PC, a mobile phone, a desktop computer, a printer, a scanner, a monitor, a set-top box, an entertainment control unit (e.g., a gaming console or automotive entertainment unit), a digital camera, an appliance, a portable music player, or a digital video recorder. In further implementations, the computer device 800 may be any other electronic device that processes data.

The following examples pertain to further embodiments.

In one example, an apparatus includes a circuit board comprising: a plurality of layers including interconnects to carry processor-to-processor signaling between a first processor and a second processor; a first connector adapted to a first peripheral portion of the circuit board to couple to a first contact member of the first processor and a second connector adapted to a second peripheral portion of the circuit board to couple to a first contact member of the second processor.

In an example, the interconnects of the circuit board are spatially separated from memory interconnects of a baseboard that couple between the first processor and a first portion of a system memory coupled to the first processor.

In an example, the circuit board is separate from the baseboard and is not adapted thereto.

In an example, the baseboard comprises at least one voltage regulator to power the first processor and the second processor, where the circuit board is to carry the processor-to-processor signaling without interference from the at least one voltage regulator.

In an example, the circuit board comprises an auxiliary circuit board.

In an example, the first contact member of the first processor comprises a stepped edge connector, and the first connector comprises a stepped pin assembly to mate with the stepped edge connector of the first processor.

In an example, the circuit board is formed of an ultra-low loss material.

In an example, the circuit board does not include keep-out zones for adaptation of integrated circuits.

In an example, the circuit board further comprises one or more additional connectors to mate with one or more accelerator devices, the circuit board comprising an auxiliary circuit board, where the first processor and the second processor are adapted to a baseboard.

In another example, an apparatus has a circuit board comprising: a plurality of layers including interconnects to carry processor-to-processor signaling between a first processor package and a second processor package; a first connector affixed to a first peripheral portion of the circuit board to mate with a first edge connector of the first processor package; and a second connector affixed to a second peripheral portion of the circuit board to mate with a first edge connector of the second processor package.

In an example, the circuit board comprises an auxiliary circuit board separate from a baseboard to which the first processor package and the second processor package are adapted, where the auxiliary circuit board is not adapted to the baseboard.

In an example, the auxiliary circuit board is formed of an ultra-low loss material and the baseboard is formed of an epoxy laminate material.

In an example, the circuit board does not include locations for adaption of integrated circuits.

In an example, the first edge connector of the first processor package comprises a stepped edge connector having at least two levels of contacts, and the first connector comprises a stepped pin assembly having at least two levels of contacts to mate with the stepped edge connector of the first processor package.

In a still further example, a system comprises: a first baseboard having a first processor package and a second processor package adapted thereto, the first baseboard further having a plurality of memory modules adapted thereto, where the first baseboard has one or more layers including first interconnects to carry processor-to-memory signaling between the first processor package and at least some of the plurality of memory modules and second interconnects to carry processor-to-memory signaling between the second processor package and at least some of the plurality of memory modules; and a first auxiliary board to carry processor-to processor signaling between the first processor package and the second processor package, where the first baseboard does not include interconnects to carry the processor-to-processor signaling between the first processor package and the second processor package.

In an example, the system comprises a symmetric multiprocessor server.

In an example, the first auxiliary board comprises a plurality of layers having second interconnects to carry the processor-to-processor signaling between the first processor package and the second processor package.

In an example, the plurality of layers further comprises third interconnects to carry signaling between at least one of the first processor package and the second processor package and a device adapted to the first auxiliary board.

In an example, the first baseboard further comprises a connector to provide interconnection between the first baseboard and a second baseboard having at least one other processor package.

In an example, the first processor package is to communicate with the second processor package via the first auxiliary circuit board and without use of socket pins or solder balls.

Understand that various combinations of the above examples are possible.

Note that the terms "circuit" and "circuitry" are used interchangeably herein. As used herein, these terms and the term "logic" are used to refer to alone or in any combination, analog circuitry, digital circuitry, hard wired circuitry, programmable circuitry, processor circuitry, microcontroller circuitry, hardware logic circuitry, state machine circuitry and/or any other type of physical hardware component. Embodiments may be used in many different types of systems. For example, in one embodiment a communication device can be arranged to perform the various methods and techniques described herein. Of course, the scope of the present invention is not limited to a communication device, and instead other embodiments can be directed to other types of apparatus for processing instructions, or one or more machine readable media including instructions that in response to being executed on a computing device, cause the device to carry out one or more of the methods and techniques described herein.

Embodiments may be implemented in code and may be stored on a non-transitory storage medium having stored thereon instructions which can be used to program a system to perform the instructions. Embodiments also may be implemented in data and may be stored on a non-transitory storage medium, which if used by at least one machine, causes the at least one machine to fabricate at least one integrated circuit to perform one or more operations. Still further embodiments may be implemented in a computer readable storage medium including information that, when manufactured into a SoC or other processor, is to configure the SoC or other processor to perform one or more operations. The storage medium may include, but is not limited to, any type of disk including floppy disks, optical disks, solid state drives (SSDs), compact disk read-only memories (CD-ROMs), compact disk rewritables (CD-RWs), and magneto-optical disks, semiconductor devices such as read-only memories (ROMs), random access memories (RAMs) such as dynamic random access memories (DRAMs), static random access memories (SRAMs), erasable programmable read-only memories (EPROMs), flash memories, electrically erasable programmable read-only memories (EEPROMs), magnetic or optical cards, or any other type of media suitable for storing electronic instructions.

## Claims

1. A system comprising:
a first baseboard (410, 510) having a first processor package (420, 520) and a second processor package (420, 520) respectively adapted thereto, the first baseboard (410, 510) further having a plurality of memory modules (440, 540) adapted thereto, wherein the first baseboard (410, 510) has one or more layers including first interconnect means for carrying processor-to-memory signaling between the first processor package (420, 520) and at least some of the plurality of memory modules (440, 540) and second interconnect means for carrying processor-to-memory signaling between the second processor package (420, 520) and at least some of the plurality of memory modules (440, 540); and
a first auxiliary board (430, 530) for carrying processor-to-processor signaling between the first processor package (420, 520) and the second processor package (420, 520) wherein the first auxiliary board (430, 530) is directly coupled to the first processor package (420, 520) and the second processor package (430, 530), and wherein the first baseboard (410, 510) does not include interconnect means for carrying the processor-to-processor signaling between the first processor package (420, 520) and the second processor package (420, 520).

2. The system of claim **1,** wherein the system comprises a symmetric multiprocessor server.

3. The system of claim **1,** wherein the first auxiliary board (430, 530) comprises a plurality of layers having a plurality of second interconnect means for carrying the processor-to-processor signaling between the first processor package (420, 520) and the second processor package (420, 520).

4. The system of claim 3, wherein the plurality of layers further comprises third interconnect means for carrying signaling between at least one of the first processor package (420, 520) and the second processor package (420, 520) and a device adapted to the first auxiliary board (430, 530).

5. The system of claim 4, wherein the first baseboard (410, 510) further comprises connector means for providing interconnection between the first baseboard (410, 510) and a second baseboard (410, 510) having at least one other processor package (420, 520).

## Patentansprüche

1. System, das Folgendes umfasst:
eine erste Grundplatte (410, 510), die eine erste Prozessorbaugruppe (420, 520) bzw. eine zweite Prozessorbaugruppe (420, 520) aufweist, die daran eingerichtet sind, wobei die erste Grundplatte (410, 510) ferner mehrere Speichermodule (440, 540) aufweist, die daran eingerichtet sind, die erste Grundplatte (410, 510) eine oder mehrere Schichten aufweist, die erste Verbindungsmittel zum Führen einer Prozessor-zu-Speicher-Signalisierung zwischen der ersten Prozessorbaugruppe (420, 520) und mindestens einem Teil der mehreren Speichermodule (440, 540) und zweite Verbindungsmittel zum Führen einer Prozessor-zu-Speicher-Signalisierung zwischen der zweiten Prozessorbaugruppe (420, 520) und mindestens einem Teil der mehreren Speichermodule (440, 540) enthalten; und
eine erste Hilfsplatine (430, 530) zum Führen einer Prozessor-zu-Prozessor-Signalisierung zwischen der ersten Prozessorbaugruppe (420, 520) und der zweiten Prozessorbaugruppe (420, 520), wobei die erste Hilfsplatine (430, 530) an die erste Prozessorbaugruppe (420, 520) und die zweite Prozessorbaugruppe (430, 530) direkt gekoppelt ist und die erste Grundplatte (410, 510) kein Verbindungsmittel zum Führen der Prozessor-zu-Prozessor-Signalisierung zwischen der ersten Prozessorbaugruppe (420, 520) und der zweiten Prozessorbaugruppe (420, 520) enthält.

2. System nach Anspruch 1, wobei das System einen symmetrischen Multiprozessorserver umfasst.

3. System nach Anspruch 1, wobei die erste Hilfsplatine (430, 530) mehrere Schichten umfasst, die mehrere zweite Verbindungsmittel zum Führen der Prozessor-zu-Prozessor-Signalisierung zwischen der ersten Prozessorbaugruppe (420, 520) und der zweiten Prozessorbaugruppe (420, 520) aufweisen.

4. System nach Anspruch 3, wobei die mehreren Schichten ferner dritte Verbindungsmittel zum Führen einer Signalisierung zwischen der ersten Prozessorbaugruppe (420, 520) und/oder der zweiten Prozessorbaugruppe (420, 520) und einer Vorrichtung, die an der ersten Hilfsplatine (430, 530) eingerichtet ist, umfassen.

5. System nach Anspruch 4, wobei die erste Grundplatte (410, 510) ferner Verbindermittel zum Bereitstellen einer Verbindung zwischen der ersten Grundplatte (410, 510) und einer zweiten Grundplatte (410, 510), die mindestens eine weitere Prozessorbaugruppe (420, 520) aufweist, umfasst.

## Revendications

1. Système comprenant :
une première carte mère (410, 510) ayant un premier boîtier de processeur (420, 520) et un deuxième boîtier de processeur (420, 520) respectivement adaptés à celle-ci, la première carte mère (410, 510) ayant en outre une pluralité de modules de mémoire (440, 540) adaptés à celle-ci, dans lequel la première carte mère (410, 510) a une ou plusieurs couches comprenant des premiers moyens d'interconnexion pour transporter une signalisation processeur-à-mémoire entre le premier boîtier de processeur (420, 520) et au moins certains de la pluralité de modules de mémoire (440, 540) et des deuxièmes moyens d'interconnexion pour transporter une signalisation processeur-à-mémoire entre le deuxième boîtier de processeur (420, 520) et au moins certains de la pluralité de modules de mémoire (440, 540) ; et
une première carte auxiliaire (430, 530) pour transporter une signalisation processeur-à-processeur entre le premier boîtier de processeur (420, 520) et le deuxième boîtier de processeur (420, 520), dans lequel la première carte auxiliaire (430, 530) est directement reliée au premier boîtier de processeur (420, 520) et au deuxième boîtier de processeur (430, 530), et dans lequel la première carte mère (410, 510) ne comprend pas de moyens d'interconnexion pour transporter la signalisation processeur-à-processeur entre le premier boîtier de processeur (420, 520) et le deuxième boîtier de processeur (420, 520).

2. Système selon la revendication 1, dans lequel le système comprend un serveur multiprocesseur symétrique.

3. Système selon la revendication 1, dans lequel la première carte auxiliaire (430, 530) comprend une pluralité de couches ayant une pluralité de deuxièmes moyens d'interconnexion pour transporter la signalisation processeur-à-processeur entre le premier boîtier de processeur (420, 520) et le deuxième boîtier de processeur (420, 520).

4. Système selon la revendication 3, dans lequel la pluralité de couches comprend en outre des troisièmes moyens d'interconnexion pour transporter une signalisation entre au moins l'un du premier boîtier de processeur (420, 520) et du deuxième boîtier de processeur (420, 520) et un dispositif adapté à la première carte auxiliaire (430, 530).

5. Système selon la revendication 4, dans lequel la première carte mère (410, 510) comprend en outre des moyens de connexion pour fournir une interconnexion entre la première carte mère (410, 510) et une deuxième carte mère (410, 510) ayant au moins un autre boîtier de processeur (420, 520).
